# EUROPEAN PATENT APPLICATION

(11) **EP 3 576 260 A1**
(43) Date of publication of application: **04.12.2019**
(21) Application number: 17894648.9
(22) Date of filing: 15.12.2017
(51) Int. Cl.: H02K 5/08

(54) **ROTATING ELECTRICAL MACHINE**

(30) Priority: 27.01.2017 WO PCT/JP2017/002845
(71) Applicant: Hitachi Industrial Equipment Systems Co., Ltd., Tokyo 101-0022 (JP)
(72) Inventor: TAKAHASHI, Shuuichi, Tokyo 101-0022 (JP); YONEOKA, Yasuei, Tokyo 101-0022 (JP); SUZUKI, Toshifumi, Tokyo 101-0022 (JP); SAKAI, Toru, Tokyo 101-0022 (JP); TAKAHASHI, Daisaku, Tokyo 101-0022 (JP); SAKURAI, Jun, Tokyo 101-0022 (JP); KURAI, Daisuke, Tokyo 101-0022 (JP)
(74) Representative: MERH-IP Matias Erny Reichl Hoffmann Patentanwälte PartG mbB
(86) International application number: PCT/JP2017/045035
(87) International publication number: WO 2018/139100

(57) **Abstract**

A rotating electrical machine that comprises: a stator in which a plurality of core units that have a core and a coil are annularly arranged around a shaft center; a rotor that faces a flux end surface of the stator in the shaft-center direction with a prescribed gap therebetween; a housing that houses the stator and the rotor and has an outlet that guides a lead wire for the stator to the outside; and a resin that integrally molds the stator and an inner circumferential surface of the housing that includes the outlet. The inner diameter of the outlet becomes larger from the shaft-center side to the radial-direction outside. The outlet has an elastic member that keeps the resin from flowing to the outside of the housing. The elastic member has a hollow part through which the lead wire passes from the shaft-center side to the radial-direction outside. Pressure from a rotary-shaft radial direction seals between the hollow part and the lead wire. The resin fills to the shaft-center side of the hollow part or to one portion of the hollow part.

## Description

### TECHNICAL FIELD

The present invention relates to a rotating electrical machine, and particularly to a rotating electrical machine which includes a stator to be fixed to a housing by molding.

### BACKGROUND ART

A rotating electrical machine includes a through hole which is provided in a housing to lead out a wire from a coil to the outside of the housing in order to supply power to the coil of a stator. In a case where the stator is fixed to the housing by resin molding in the rotating electrical machine, a resin is leaked out of a gap between the through hole and the wire which comes out of the through hole.

For example, Patent Literature 1 is disclosed to solve such a problem. Patent Literature 1 discloses a configuration which includes a housing of a rotating electrical machine of a radial gap type and a wire leading-out portion of a taper shape which becomes narrower from the inner portion of the rotating electrical machine to the outside, and in which a sealing member which is formed in a taper shape approximating the wire leading-out portion and includes a hollow portion through which the wire passes is inserted from the inner portion of the housing to prevent a molding resin from being leaked.

### CITATION LIST

### PATENT LITERATURE

PATENT LITERATURE 1: JP-A-2013-240215

### SUMMARY OF INVENTION

### TECHNICAL PROBLEM

However, in the structure of Patent Literature 1, the sealing member is necessarily inserted from the inside of the housing, and the outlet portion is needed to be provided as far from the stator as a coil end of the stator does not cause trouble in the work. Therefore, there is a problem that the rotating electrical machine extends in the axial direction. In particular, a shortening length in the axial direction is an important object for the axial gap type rotating electrical machine. In a case where the outlet portion is disposed close to the coil end to shorten the length in the axial direction, the wire is bent at a steep angle. Therefore, there is a concern that the wire is damaged and reliability is degraded. In addition, the housing is pressed by the coil end is also wound with the sealing member. Therefore, there is a problem that the working space becomes narrow extremely.

In addition, the sealing member becomes wide as it goes toward the inside of the housing. Therefore, when a molding die is inserted at resin molding, the sealing member may fall down inside the housing. Further, since the sealing member is not visible from the outside of the housing, it causes degradation in workability.

Therefore, there is desired a rotating electrical machine which is excellent in workability while securing compactness and reliability.

### SOLUTION TO PROBLEM

In order to solve the above problem, the configuration of claim is applied. As an example, a rotating electrical machine includes a stator in which a plurality of core units which include cores and coils are disposed in an annular shape about an axial center, a rotor which faces a flux end surface of the stator via a predetermined gap in an axial-center direction, a housing which accommodates the stator and the rotor and includes an outlet which guides a lead wire of the stator to an outside, and a resin which molds the stator and an inner circumferential surface of the housing which includes the outlet. The outlet has an inner diameter which becomes larger from a side of the axial center toward an outside in a radial direction, and includes an elastic member which keeps the resin from flowing to an outside of the housing. The elastic member is configured to include a hollow portion through which the lead wire passes through from the side of the axial center toward the outside in the radial direction, and seals a portion between the hollow portion and the lead wire by a pressure from a rotary-shaft radial direction. The resin fills up to a side of the axial center or a part of the hollow portion.

Alternatively, a rotating electrical machine includes a stator which includes a core and a coil wound around the core, a rotor which rotates by a magnetic flux from the stator, a housing which accommodates the stator and includes an outlet portion, the outlet portion guiding to an outside a lead wire which is connected to the coil, and a resin which molds the stator to the housing which includes the outlet portion. The outlet portion includes a through hole of which an inner diameter becomes larger from a side of an axial center toward an outside in a radial direction, the through hole including a sealing member. The sealing member includes a hollow portion through which the lead wire passes from the side of the axial center to the outside in the radial direction, and seals a portion between the through hole and the sealing member by a pressure from a rotary-shaft radial direction. The resin fills up to a side of the axial center or a part of the outlet portion.

Alternatively, a rotating electrical machine includes a stator which includes a stator winding, a rotor, a housing which accommodates the stator and includes a through hole through which a lead wire from the stator winding passes, and a resin which fixes an inner wall of the housing including the through hole and the stator. The through hole includes an inner wall of which an inner diameter becomes smaller as it goes from an outside in a rotary-shaft radial direction to an inner side, and an elastic member which comes into contact with at least a part of the inner wall. The elastic member includes a hollow portion through which the lead wire passes, and is deformed by a pressure from an outside. The resin fills a side of an axial center or a part of the hollow portion.

### ADVANTAGEOUS EFFECTS OF INVENTION

According to an aspect of the invention, it is possible to provide a rotating electrical machine which can improve workability and is compact and highly reliable.

Other objects, configurations, effects will become apparent from the following description of exemplary embodiments.

### BRIEF DESCRIPTION OF DRAWINGS

FIG. 1 is an exploded perspective view illustrating a configuration of an axial gap type rotating electrical machine according to a first embodiment to which the invention is applied.
FIG. 2 is an exploded perspective view illustrating a configuration of an armature of the axial gap type rotating electrical machine according to the first embodiment.
FIG. 3 is a cross-sectional view for describing a manufacturing process of the axial gap type rotating electrical machine according to the first embodiment.
FIG. 4 is a perspective view illustrating a housing of the axial gap type rotating electrical machine according to the first embodiment.
FIG. 5 is a cross-sectional view illustrating a wire leading-out portion of the axial gap type rotating electrical machine according to the first embodiment.
FIG. 6 is a diagram illustrating a modification of the wire leading-out portion of the axial gap type rotating electrical machine according to the first embodiment.
FIG. 7 is a diagram illustrating a modification of a sealing member of the axial gap type rotating electrical machine according to the first embodiment.
FIG. 8 is a cross-sectional view illustrating the wire leading-out portion of the axial gap type rotating electrical machine according to a modification of the first embodiment.
FIG. 9 is a cross-sectional view illustrating the wire leading-out portion of an axial gap type rotating electrical machine according to a second embodiment to which the invention is applied.
FIG. 10 is a cross-sectional view illustrating the wire leading-out portion of the axial gap type rotating electrical machine according to a third embodiment to which the invention is applied.
FIG. 11 is a diagram illustrating a modification of the sealing member of an axial gap type rotating electrical machine according to a fourth embodiment to which the invention is applied.
FIG. 12 is a diagram illustrating a modification of the sealing member of the axial gap type rotating electrical machine according to the fourth embodiment to which the invention is applied.
FIG. 13 is a diagram illustrating a modification of the sealing member of the axial gap type rotating electrical machine according to the fourth embodiment to which the invention is applied.
FIG. 14 is a diagram illustrating a modification of the sealing member of the axial gap type rotating electrical machine according to the fourth embodiment to which the invention is applied.

### DESCRIPTION OF EMBODIMENTS

### First Embodiment

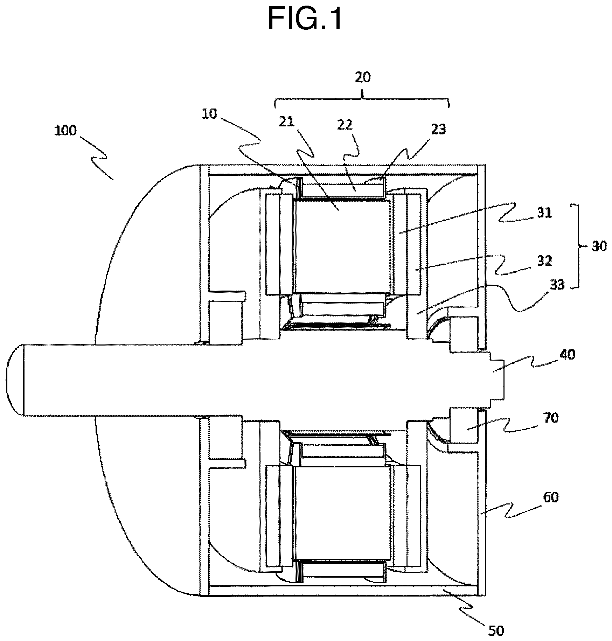

Hereinafter, embodiments of the invention will be described using the drawings. FIG. 1 is a vertical cross-sectional view taken in an axial direction illustrating a schematic configuration of an axial gap type permanent magnetic synchronous motor 100 of a double rotor system (hereinafter, simply referred to as "motor 100" in some cases) according to a first embodiment to which the invention is applied.

The motor 100 is configured such that a stator 10 disposed in a donut shape along an inner circumferential surface of a housing 50 is interposed with a predetermined air gap by two disk-like rotors 30 in a rotary shaft direction to face each other. The center of the disk-like rotor 30 is fixed to a rotary shaft 40. The rotary shaft 40 is disposed to pass through the center portion of the stator 10, and both ends are fixed to a bracket 60 through a bearing 70 to rotate. The end bracket 60 is fixed near the end of both openings of the housing 50 of which the inner circumference has a schematically cylindrical shape.

The rotor 30 includes a permanent magnetic 31 in a circular base 33 through a yoke 32. The permanent magnetic is made of a plurality of flat magnets or one annular magnet which has an inner circumference of an approximate fan shape about the rotary shaft, and has polarities different in the rotation direction. Further, a ferrite magnet is applied as the permanent magnetic 31 in this embodiment, but the invention is not limited thereto.

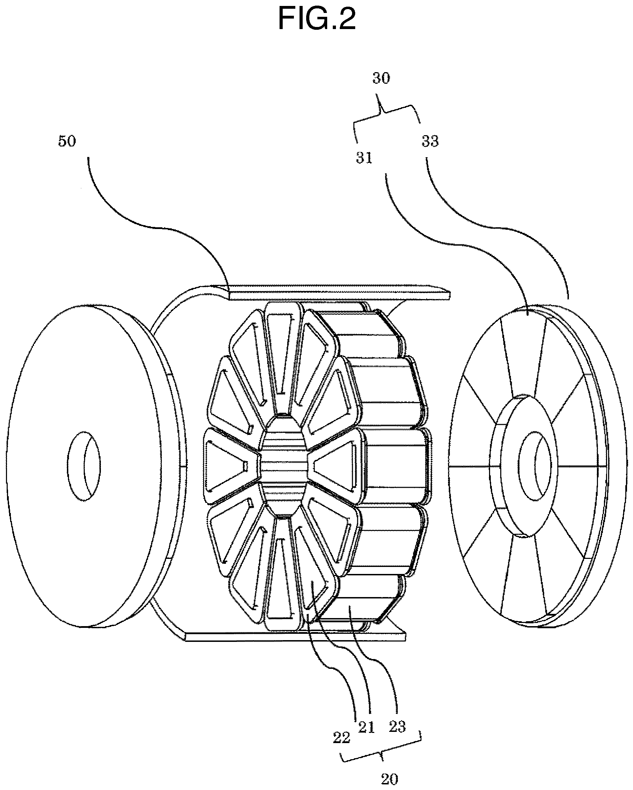

FIG. 2 is a perspective view schematically illustrating the configuration of an armature of the motor 1. The stator 10 includes 12 core units 20 which are disposed along the inner circumference of the housing 30 with the rotary shaft 40 (not illustrated) as the center direction. One core unit 20 forms one slot. In addition, the core units 20 and the inner circumferential surface of the housing 50 are integrally molded to each other using resin described below, and simultaneously fix the stator in the housing.

The core unit 20 includes an iron core 21, a bobbin 22, and a coil 23. The iron core 21 is a stacked iron core made of a cylinder of which the end surface facing the rotor 30 is an approximate trapezoidal shape. The stacked iron core is a thin plate member (containing foil pieces), and is obtained by stacking plate pieces with a width increasing as it goes from a rotary axial center A to the inner circumferential surface of the housing. In addition, the iron core 21 is not limited to the above structure, but may be a pressed powder core or a cutting core, or may be a core of which the cross section in the rotary shaft direction is a T, H, or I shape. Further, the magnetic material is described using an amorphous metal, but not limited thereto.

The bobbin 22 is made of a cylindrical shape of which the inner diameter is almost the same as the outer diameter of the iron core 21. In the vicinity of both openings of the bobbin 22, there is provided a flange portion which extends by a predetermined width in a vertical direction from the entire outer circumference of the outer cylinder. The coil 23 is wound between both flange portions of the outer cylinder.

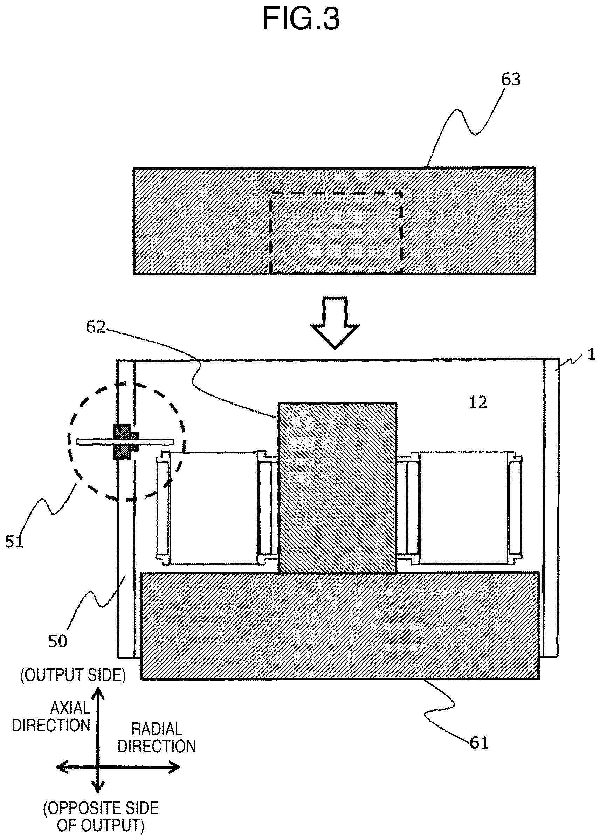

FIG. 3 schematically illustrates a resin molding process of integrally forming the core units 20 and the inner circumference of the housing 50. In the inside of the housing 50, a lower die 61 of which the inner diameter is substantially matched is inserted. A cylindrical middle die 62 is disposed in the center of the lower die 61 to form a core space through which the rotary shaft passes through from the opposite opening of the housing 50 later. The core units 20 are arranged in an annular shape about the middle die 62. At this time, the flange portion of the bobbin is configured to perform positioning in the radial direction, and positioning in a rotation direction of the rotary shaft with respect to the adjacent core unit 20.

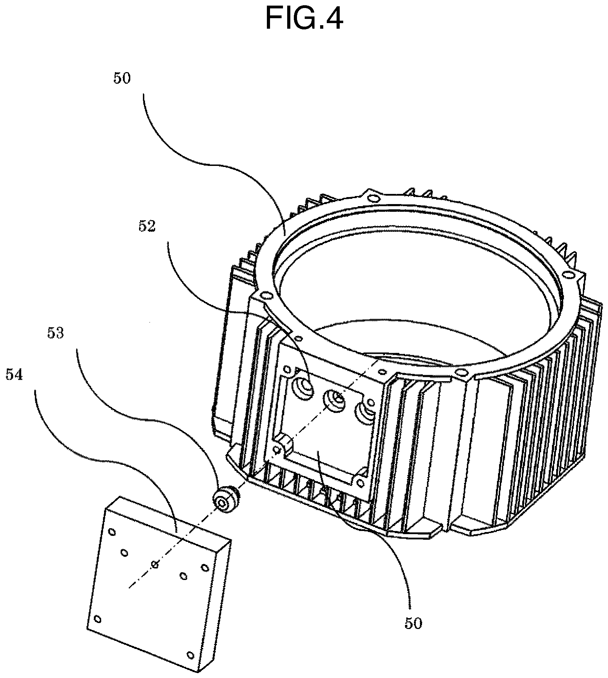

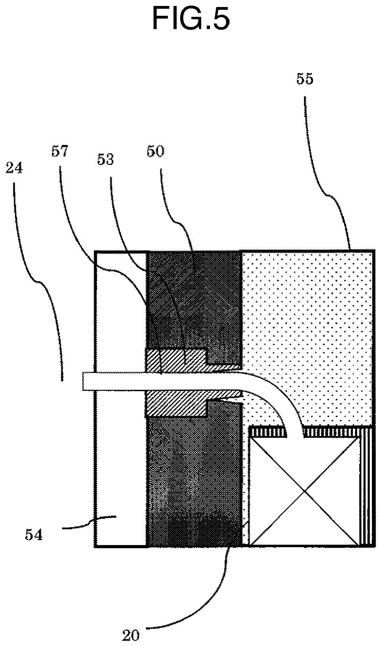

Thereafter, an upper die 63 which has an outer diameter almost matched with the inner diameter of the housing 50 and has a cylindrical space through which the middle die 62 passes is inserted from the opening of the housing on the opposite side to the lower die 61, and interposes and supports the core unit 20. Thereafter, resin is inserted from the upper die 63, or from both the upper die 63 and the lower die 61. The resin fills a space between the core units 20, and flows toward the inner circumferential surface of the housing 50, the middle die 62, and the surface facing the rotor 30 of the flange portion of the bobbin with almost no gap. In a part of the housing 50, there is provided a wire leading-out portion 51 to guide the wire (lead wire) connected to the winding from the stator 10 to the outside of the housing. FIG. 4 illustrates an exterior view of the wire leading-out portion 51, and FIG. 5 illustrates an enlarged cross-sectional view.

The wire leading-out portion 51 illustrated in FIGS. 4 and 5 is a concave portion which is provided in the side surface of the housing. In the bottom of the concave portion, a plurality of through holes 52 are disposed where a sealing member (elastic member) 53 is disposed. The through hole 52 is formed to have a diameter which becomes smaller as it goes to the inside of the housing. In this embodiment, the diameter is narrowed by steps in the middle. The sealing member 53 is configured to be pressed and fitted such that the outer diameter is almost the same as the inner diameter of the through hole 52. The sealing member 53 includes a hollow portion 57 through which the wire passes in the inner portion when being disposed in the through hole 52. When being molded, the wire from the hollow portion 57 is led out to the outside of the housing, and the sealing member 53 is pressed from the outside such that the resin is not leaked out and cured.

As a method of pressing the sealing member 53, for example, there is a method in which a fixing member 54 having a hole having the same shape as the concave portion to pass the wire is inserted from above the sealing member 53, and four corners are screwed. Alternatively, the fixing member 54 may be pressed to the housing during the molding using a press machine, or the housing is wound using a wire material from above the fixing member 54 to fix. In any method, the sealing member 53 may be pressed by the fixing member 54 as much as a deformation resin 55 is not leaked out.

Further, the fixing member 54 may be configured also to serve as the bottom plate of a terminal box. With this configuration, when the terminal box member is installed, the sealing process at the time of molding can be implemented at the same time. In addition, the sealing performance can be kept by the deformation of the sealing member 53.

Further, the sealing member 53 may be located in the inner portion of the through hole 52 in a state where the wire is wound by an outer diameter not coming into contact with the inner diameter of the through hole 52. The through hole 52 is an outlet to lead out the wire from the core unit 20 to the outside of the housing. The sealing member 53 is an elastic body such as rubber, and desirably a material which is deformed by a pressure at the time of molding. The cross section of the sealing member 53 in FIG. 4 is almost the circle similar to the inner diameter of the through hole 52. In a case where the through hole 52 is not a circular shape, the sealing member 53 is desirably formed along the inner diameter of the through hole 52. In this embodiment, the manufacturing becomes simple, so that the sealing performance at the time of molding is more improved. The circular sealing member will be described as an example.

If the sealing member 53 is pressed from the outside of the housing when resin molding is performed, the outer diameter and the inner diameter of the sealing member are deformed. Therefore, a molding resin 55 is stopped at a side of the axial center or a part of the hollow portion 57 of the sealing member 53. It is possible to prevent the resin from leaking to the outside of the housing. The sealing member 53 fixed by inserting the molding resin 55 to a part thereof can also serve to prevent a water drop from entering the housing 50.

In particular, in a case where the outer diameter of the sealing member 53 at the time of deforming becomes larger than the inner diameter of the through hole 52, it is not possible for the sealing member 53 to deform the external shape since the sealing member is inserted in the through hole 52, and the sealing member 53 deforms the diameter of the hole of the inner potion of the sealing member 52 to be narrow much more.

In this embodiment, the number of through holes 52 is set to three in the drawing. However, a plurality of wires can be made to pass one through hole if the inner diameters of the through hole 52 and the sealing member 53 are widened. Alternatively, in a case where the motor 100 is a three-phase motor, the through holes 52 may be provided at six places in total since there are wires of the input end and the output end of each phase. It is preferable that one wire is set to one sealing member since the sealing member is evenly deformed from all directions with respect to the wire, and the flow path of the molding resin can be closed evenly.

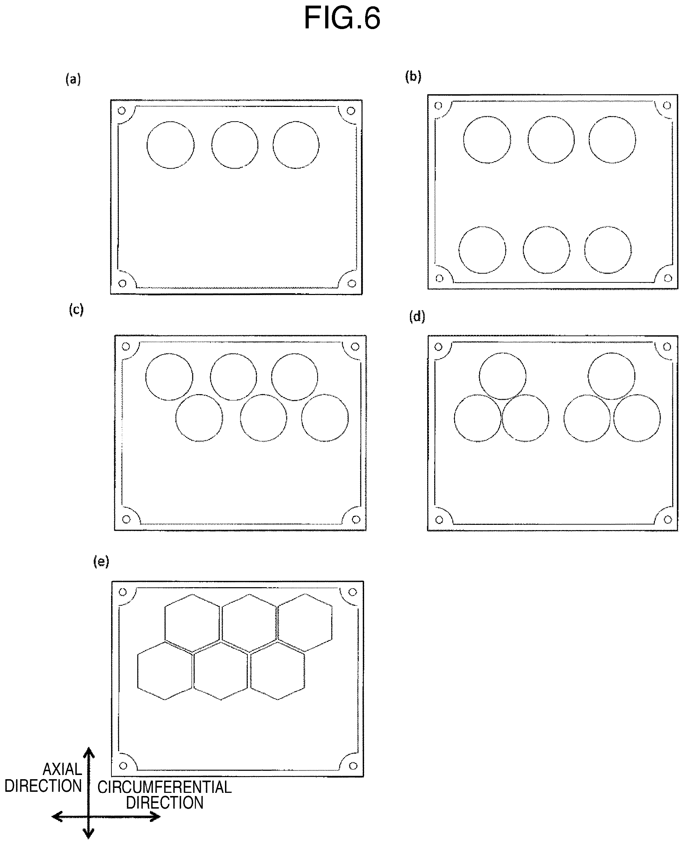

In FIG. 4, as illustrated in FIG. 6(a), the through holes 52 are provided to be shifted to one side away out in the axial direction in the bottom surface of the wire leading-out portion 51. This is because the wire is led out only from one side in the end surface in the axial direction of the stator in this embodiment. In a case where the wire is led out from both end surfaces of the stator, the through holes 52 by necessary number as illustrated in FIG. 6(b) may be provided to be shifted to both sides in the axial direction on the bottom surface of the wire leading-out portion 51.

In addition, in a case where the through holes are provided to be shifted only to one side in the end surface in the axial direction, the through holes 52 may be provided in two columns as illustrated in FIGS. 6(c) and 6(d) when the width of the wire leading-out portion 51 is not made large. At this time, the through holes in the first column and the second column are disposed differently from each other, so that the through hole 52 can be densely provided. If the lead wire is bent at a steep angle, the wire may be damaged. Therefore, the through hole 52 is provided as dense as possible, and the wire in the through hole 52 located on the end side is not bent at a steep angle.

In addition, in a case where the density of the through holes 52 is increased much more, the through holes 52 may be formed in a rectangular shape as illustrated in FIG. 6(e) instead of the circular shape. In this case, the sealing member 53 is also desirably formed in a polygonal shape.

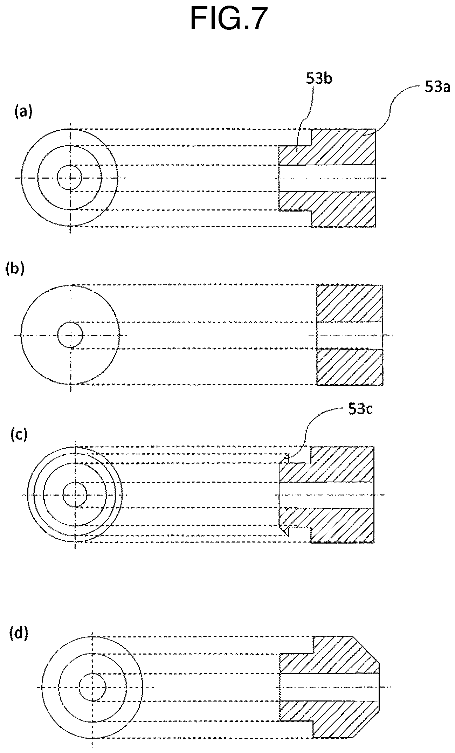

FIG. 7 illustrates an example of the shape of the sealing member 53. FIG. 7(a) is the sealing member 53 illustrated in FIG. 4. The shape of (a) includes a large diameter portion 53a of the sealing member and a small diameter portion 53b of which the outer diameter is narrower than the large diameter portion. In the inner portion, the hollow portion 57 is provided to pass through the entire sealing member. The diameter of the hollow portion 57 is constant in the large diameter portion 53a and the small diameter portion 53b.

Since the large diameter portion 53a and the small diameter portion 53b are different in thickness, a surface corresponding to the housing is formed in the boundary between the large diameter portion 53a and the small diameter portion 53b. With the contact surface pressed to abut on the housing, the molding resin is not leaked from the contact surface to the outside of the housing even if the molding resin is leaked out from the gap between the small diameter portion 53b and the through hole 52.

Paying attention only on the effect of suppressing the leakage of the molding resin with the contact surface pressed to abut on the housing, a shape having no small diameter portion 53b of the sealing member 53 illustrated in FIG. 6(b) may be employed.

FIGS. 7(a), 7(c), and 7(d) illustrate the shape having the small diameter portion, and can improve the insulating property of the wire to the housing. In FIG. 7(c), a hook 53c is provided in the small diameter portion 53b compared to (a). With this configuration, the sealing member 53 can be made hard to be taken away in the middle of fixing the housing and the stator with a die. The hook 53c may be provided all over the periphery as illustrated in (c), or may be provided discontinuously in the circumferential direction.

FIG. 7(d) is a diagram in which corners of the end surface on the outer circumference side of the housing of the large diameter portion 53a of the sealing member 53 is cut off to be a taper shape with respect to the axial center. With such a shape, a force applied in a direction perpendicular to the wire is increased when the sealing member 53 is pressed. Therefore, since the sealing member 53 is deformed in a direction of narrowing the hollow of the inner portion, the effect of preventing the leakage of the molding resin is large compared to the other shapes.

According to the motor 100 of this embodiment described, the workability can be improved without causing the leakage of the molding resin by providing the through hole 52 in the housing and by inserting and pressing the sealing member 53. In addition, there is no need to separate the end portion much in the axial direction of the core unit and the through hole, and a rotating electrical machine can also be made compact.

In this embodiment, the electrical machine of an axial air gap type has been described as an example. However, a machine of a radial gap type may also be applied as long as the machine is an electrical machine or a power generator of a type of fixing the stator to the housing by the molding resin.

### <Modification of First Embodiment>

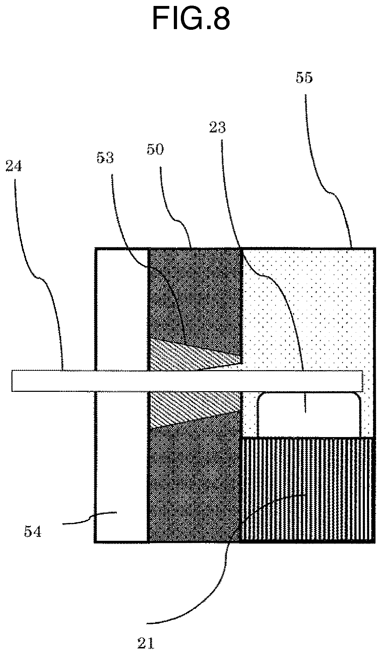

FIG. 8 illustrates a modification of the first embodiment. One of the features of the through hole 52 of this modification is a taper shape of which the inner diameter is gradually increased (expanded) as it goes from the axial center to the outside of the housing.

In addition, one of the features of the sealing member 53 is also a taper shape (pyramid shape) of which the diameter becomes small from the outside of the housing to the inside along the inner shape of the through hole 52.

In this way, the inner wall of the through hole 52 is inclined with respect to the pressing direction. Therefore, the force of pressing the sealing member 53 from the outside of the housing in the radial direction is distributed into a force of pushing the sealing member 53 in the subject direction and a force of deforming the sealing member in the axial direction. With the force of deforming the sealing member 53 in the axial direction, the outer circumference of the sealing member 53 and the inner circumference of the hollow portion 57 are deformed. The gap between the outer circumference of the sealing member 53 and the through hole 52 and the gap between the inner circumference of the hollow portion 57 and the lead wire are buried. Therefore, it is possible to prevent that the resin from being leaked to the outside.

### Second Embodiment

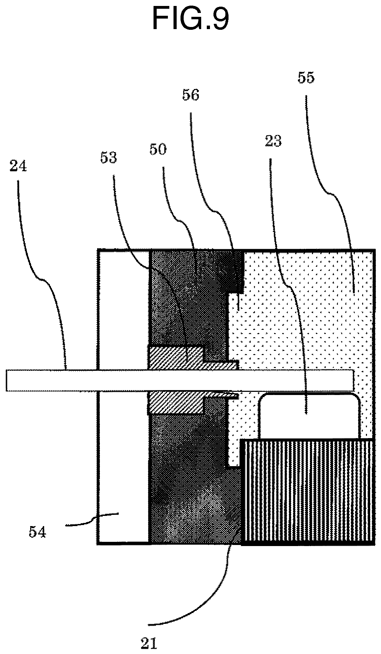

One of the features of the motor 100 of a second embodiment to which the invention is applied is that a fixing region 56 is provided on the rear side of the concave portion of the housing. Hereinafter, the description will be given using FIG. 9.

With the fixing region 56 installed on the rear side of the wire leading-out portion 51, the housing becomes thin, and a large space around the coil end can be secured. Therefore, a wire bending tool can be bent down to the through hole 52 more gently, and the reliability of the wire can be improved.

Further, the resin 55 fills even the fixing region 56. Finally, the resin is cured, and forms a portion extruding to a radial-direction outside when viewed from the stator. In other words, the resin 55 filling the surrounding of the stator 10 and the resin 55 filling the fixing region 56 are integrated to be molded.

According to the motor 100 of this embodiment, the wire does not need to be pulled out at a steep angle. Therefore, a load applying on a bending portion of the wire is reduced, and a highly-reliable rotating electrical machine can be obtained. In addition, the stress to the force in the rotary-shaft radial direction and the rotary shaft direction is improved in the stator 10, and the fixing can be made securely which can attribute to the improvement in performance of the motor 100. Further, the process of molding the fixing region 56 is performed together with the process of molding the core units 20 and the housing 50, so that the workability is improved. In addition, the fixing region 56 can be obtained through a simple process of partially thinning the thickness of the housing 50.

### Third Embodiment

One of the features of the motor 100 of a third embodiment to which the invention is applied is that a temperature sensor is provided. The description will be given about an example where a thermoelectric coupler is used as the temperature sensor. Specifically, a thermoelectric coupler 25 is wound around one of the core units 20 together with the coil 23 and pulled out to the outside of the housing as a wire.

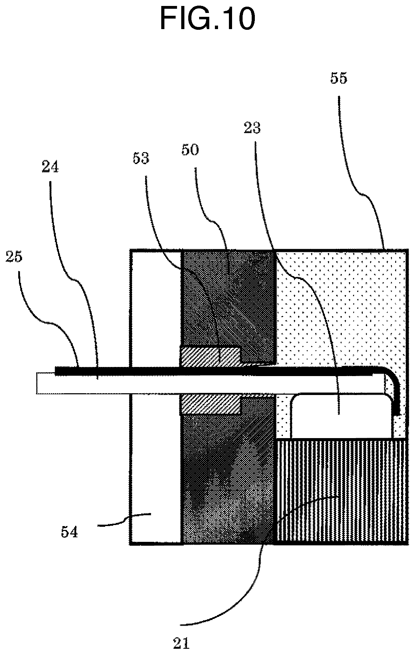

FIG. 10 illustrates a cross-sectional view of the wire leading-out portion of the third embodiment. The line of the thermoelectric coupler 25 may be taken out of the housing from one sealing member 53 like a jumper as illustrated in FIG. 10, or may be pulled out from the other sealing member.

In addition, the core unit wound with the thermoelectric coupler 25 may be one, or may be three in total for each phase of the three-phase AC system for example. At this time, when the core unit 20 winding the thermoelectric coupler 25 is disposed as close to the through hole 52 as possible, the line of the thermoelectric coupler becomes short. Therefore, the line wound the inner circumference of the housing is reduced, and the diameter of the rotor is not necessary to be pressed.

In this way, the through hole 52 and the sealing member 53 may also be applied to a wire other than a lead wire 24 connected to the coil as long as the wire is a line pulled out of the inside of the housing.

### Fourth Embodiment

One of the features of the motor 100 of a fourth embodiment to which the invention is applied is that a plurality of holes are provided in one sealing member. The configuration that one wire is disposed in one hole is common in the other embodiments.

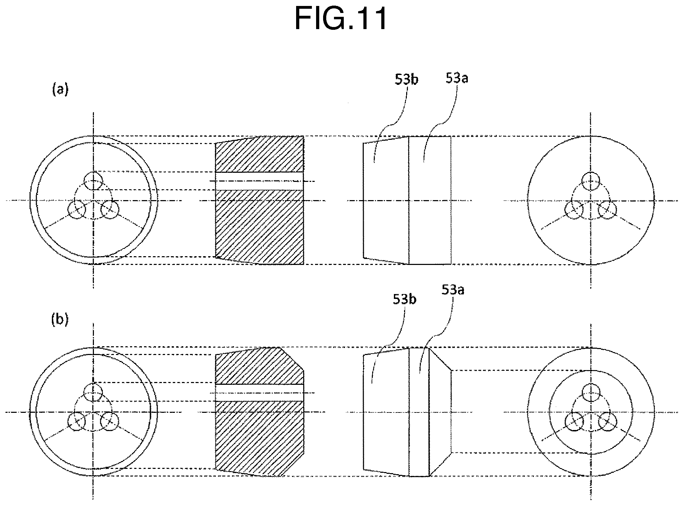

FIG. 11(a) illustrates an example in which the outer diameter of the sealing member 53 becomes narrow from the middle on the way to the inside of the housing. A certain portion of the diameter becomes the large diameter portion 53a, and the narrow portion of the diameter becomes the small diameter portion 53b. In FIG. 11(b), the sealing member 53 is made in a taper shape with respect to the axial center by cutting off the corner of the end surface on the outer circumference of the housing which is a part of the large diameter portion 53a as illustrated in FIG. 7(d).

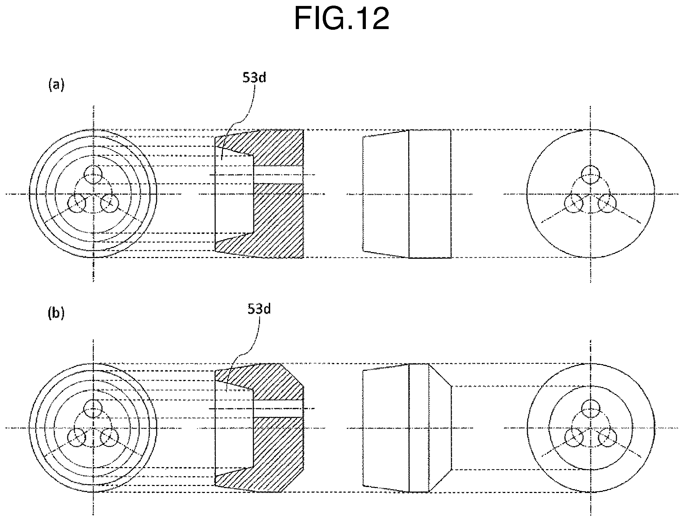

FIG. 12 illustrates a sealing member which further includes a concave portion 53d. The concave portion is formed by notching the inside of the housing almost in a circular shape compared to the sealing member of FIG. 11. Both FIGS. 12(a) and 12(b) illustrate shapes in which the hollow small diameter portion 53b is connected to the large diameter portion 53a. The thickness of the small diameter portion 53b is gradually reduced as it goes from the outside to the inside of the housing. FIG. 12(b) illustrates a shape in which the corner on the outside of the housing of the larger diameter portion is cut off similarly to FIG. 11(b). As illustrated in FIG. 12, with the concave portion 53d, a space is made in the sealing member. When the wire is led out of the housing through the sealing member, a bending angle of the wire can be made gently. This is because the wire may be damaged if the wire is bent at a steep bending angle.

In FIG. 12, the depth of the concave portion 53d is constant over the entire length of the small diameter portion, but there is no need to make the depth constant. If the concave portion 53d is made deep to secure a space enough to bend a thick wire, the space can be secured much. However, if the concave portion 53d is made too deep, there is a concern that the thickness required for the sealing becomes thin. Therefore, there is a need to appropriately adjust the depth in consideration of the thickness of the wire and a sealing pressure of the resin.

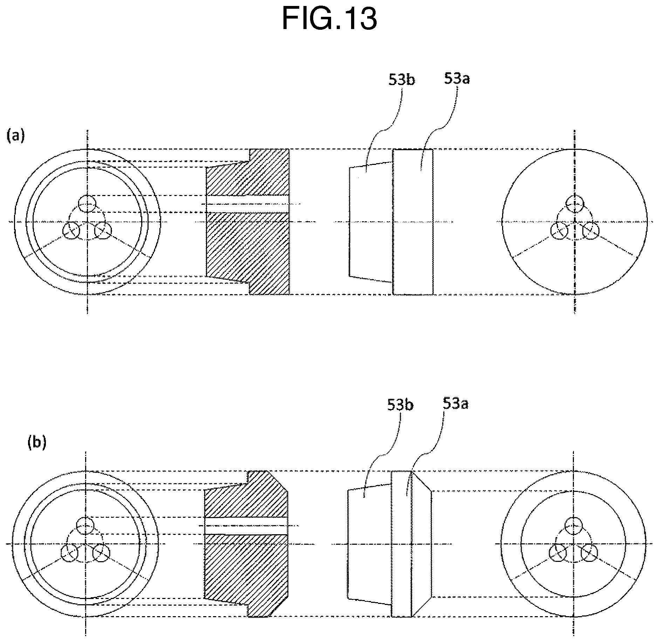

FIG. 13 illustrates a shape in which there is formed a step between the large diameter portion 53a and the small diameter portion 53b. In both FIGS. 13(a) and 13(b), the external shape of the small diameter portion is gradually narrowed. FIG. 13(b) illustrates a shape in which the corner of the large diameter portion 53a is cut off.

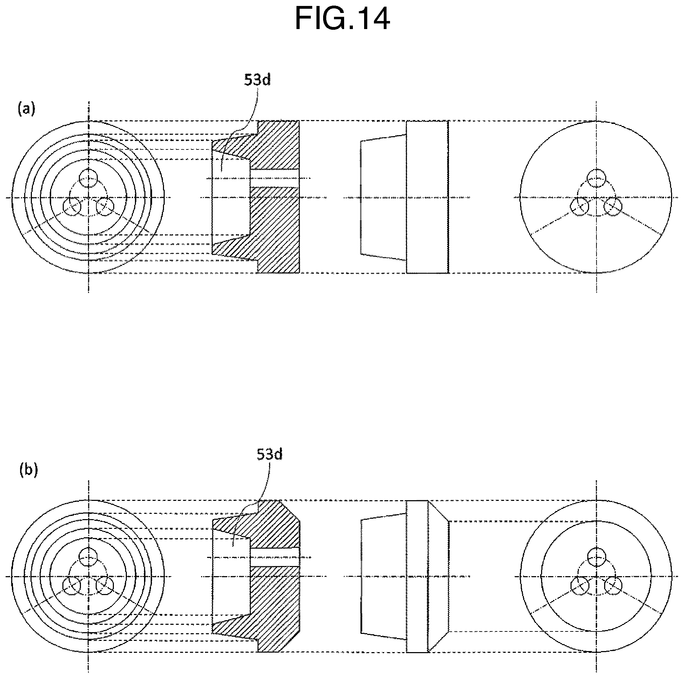

FIG. 14 illustrates an example in which the concave portion is applied to the sealing member 53 of FIG. 13. In the examples of FIGS. 11 to 14, with a plurality of holes formed with respect to one sealing member, the number of through holes 52 provided in the housing can be reduced. It is possible to alleviate a concern that the resin is leaked out from the through hole 52 to the outside of the housing. In addition, the entire length of the sealing member 53 is made equal to or longer than the thick of the housing. With the length equal to or more than the thickness the housing, it is possible to alleviate a concern that the wire comes into direct contact with the housing to cause damage.

Further, this embodiment has been described using the drawing in which three through holes are formed for one sealing member. However, the number of through holes may be three or more, or two. The number of wires to be led out of the housing and the number of holes to be formed in the housing may be designed flexibly.

### REFERENCE SIGNS LIST

- 10: stator (stator)
- 20: core unit
- 21: core
- 22: bobbin
- 23: coil
- 24: lead wire
- 30: rotor (rotor)
- 31: permanent magnetic
- 32,33: yoke
- 40: rotary shaft
- 50: housing
- 51: wire leading-out portion
- 52: through hole
- 53: sealing member
- 54: fixing member
- 55: resin
- 60: bracket
- 70: bearing

## Claims

1. A rotating electrical machine comprising:
a stator in which a plurality of core units which include cores and coils are disposed in an annular shape about an axial center;
a rotor which faces a flux end surface of the stator via a predetermined gap in an axial direction;
a housing which accommodates the stator and the rotor and includes an outlet which guides a lead wire of the stator to an outside; and
a resin which integrally molds the stator and an inner circumferential surface of the housing which includes the outlet,
wherein the outlet has an inner diameter which becomes larger from a side of the axial center toward an outside in a radial direction, and includes an elastic member which keeps the resin from flowing to an outside of the housing,
wherein the elastic member includes a hollow portion through which the lead wire passes through from the side of the axial center toward the outside in the radial direction, and seals a portion between the hollow portion and the lead wire by a pressure from a rotary-shaft radial direction,
wherein a length in the radial direction of the elastic member is equal to or more than a thickness in the radial direction of the housing, and
wherein the resin fills up to a side of the axial center or a part of the hollow portion.

2. The rotating electrical machine according to claim 1, wherein the elastic member includes a portion which matches with any dimension between a maximum diameter and a minimum diameter of the outlet, and comes into contact with an inner wall of the outlet at the portion.

3. The rotating electrical machine according to claim 2, wherein the elastic member is configured such that a corner of an end surface on an outer circumference side of the housing is formed in a taper shape with respect to the axial center.

4. The rotating electrical machine according to claim 2,
wherein the outlet includes a step in a middle of an inner wall, and
wherein the step and the elastic member come into contact.

5. The rotating electrical machine according to claim 2, further comprising:
a terminal box which is attached in a circumferential direction of the housing,
wherein an outside end surface in the radial direction of the sealing member is in contact with a plate of the terminal box on a side of the housing.

6. A rotating electrical machine comprising:
a stator which includes a core and a coil wound around the core;
a rotor which rotates by a magnetic flux from the stator;
a housing which accommodates the stator and includes an outlet portion, the outlet portion guiding to an outside a lead wire which is connected to the coil; and
a resin molds the stator to the housing which includes the outlet portion,
wherein the outlet portion includes a through hole of which an inner diameter becomes larger from a side of an axial center toward an outside in a radial direction, the through hole including a sealing member,
wherein the sealing member includes a hollow portion through which the lead wire passes from the side of the axial center to the outside in the radial direction, and seals a portion between the through hole and the sealing member by a pressure from a rotary-shaft radial direction, and
wherein the resin fills up to a side of the axial center or a part of the outlet portion.

7. The rotating electrical machine according to claim 6,
wherein the through hole includes a step in a middle of an inner wall, and
wherein the step and the sealing member come into contact.

8. The rotating electrical machine according to claim 7, wherein a sealing member includes a step along an inner wall of the through hole.

9. The rotating electrical machine according to claim 8,
wherein the housing further includes a terminal box in an outer circumference, and
wherein the sealing member is in contact with a bottom plate of the terminal box.

10. A rotating electrical machine comprising:
a stator which includes a stator winding;
a rotor;
a housing which accommodates the stator and includes a through hole through which a lead wire from the stator winding passes; and
a resin which fixes an inner wall of the housing including the through hole and the stator,
wherein the through hole includes an inner wall of which an inner diameter becomes smaller as it goes from an outside in a rotary-shaft radial direction to an inner side, and an elastic member which comes into contact with at least a part of the inner wall,
wherein the elastic member includes a hollow portion through which the lead wire passes, and is deformed by a pressure from an outside, and
wherein the resin fills a side of an axial center or a part of the hollow portion.
